# EUROPEAN PATENT APPLICATION

(11) **EP 1 804 231 A2**
(43) Date of publication of application: **04.07.2007**
(21) Application number: 06025957.9
(22) Date of filing: 14.12.2006
(51) Int. Cl.: G09G 3/34

(54) **Backlight module and driving circuit module thereof**

(30) Priority: 29.12.2005 CN 200510135960
(71) Applicant: GIGNO TECHNOLOGY CO., LTD, Datong Taipei City 103 (TW)
(72) Inventor: Lin, Feng-Li, Taishan Township Taipei County 243 (TW)
(74) Representative: TER MEER - STEINMEISTER & PARTNER GbR

(57) **Abstract**

A backlight module includes a first driving circuit board (31), a second driving circuit board (32), a first light-emitting unit (33) and a second light-emitting unit (34). The first driving circuit board has a first power supply circuit (311) and a first current return circuit (312). The second driving circuit board has a second power supply circuit (321) and a second current return circuit (322). The first light-emitting unit has a first end electrically connected to the first power supply circuit of the first driving circuit board, and a second end electrically connected to the second current return circuit of the second driving circuit board. The second light-emitting unit has a first end electrically connected to the second power supply circuit of the second driving circuit board, and a second end electrically connected to the first current return circuit of the first driving circuit board.

## Description

### BACKGROUND OF THE INVENTION

### Field of Invention

The invention relates to a backlight module and a driving circuit module thereof, and, in particular, to a backlight module with reduced cost and better lighting uniformity, and a driving circuit module thereof.

### Related Art

A typical liquid crystal display (LCD) device mainly includes a liquid crystal display unit and a backlight module, wherein the backlight module may be a bottom lighting backlight module or a side lighting backlight module.

Regardless of the type of the backlight module, at least one driving circuit board has to be provided to drive a light-emitting unit in the backlight module. At present, the most frequently used light-emitting unit is a cold cathode fluorescent lamp, and the signal for driving the light-emitting unit is a high-voltage driving signal provided by the driving circuit board.

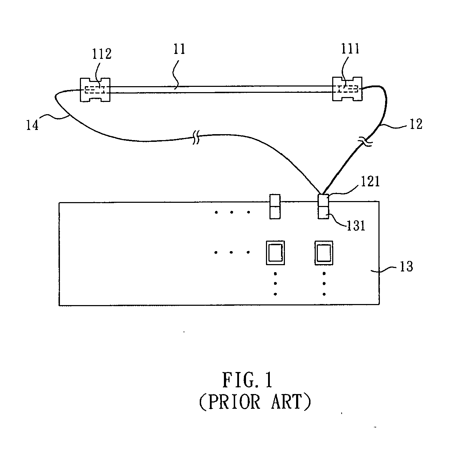

As shown in FIG. 1, in order to allow a light-emitting unit (cold cathode fluorescent lamp) 11 and a driving circuit board 13 to be smoothly connected and assembled together, the manufacturer electrically connects a first electrode 111 of the light-emitting unit 11 to a connection wire 12, which can withstand a high voltage and has a connection terminal 121, and electrically connects a second electrode 112 of the light-emitting unit 11 through a connection wire 14 to the high-voltage tolerant connection terminal 121. The connection wire 14 is then electrically connected to a connection terminal 131 of the driving circuit board 13 through the connection terminal 121. Thus, the high-voltage driving signal outputted by the driving circuit board 13 may be transmitted to the light-emitting unit 11, through the connection terminal 131, the connection terminal 121 and the connection wire 12, to drive the light-emitting unit 11. Because the connection wires 12 and 14, which are provided manually, are necessary to connect the light-emitting unit 11 to the driving circuit board 13, the production cannot be automated. Also, because the connection wire 12, the connection terminal 121 and the connection terminal 131 have to withstand a high voltage, these suitable elements are costly.

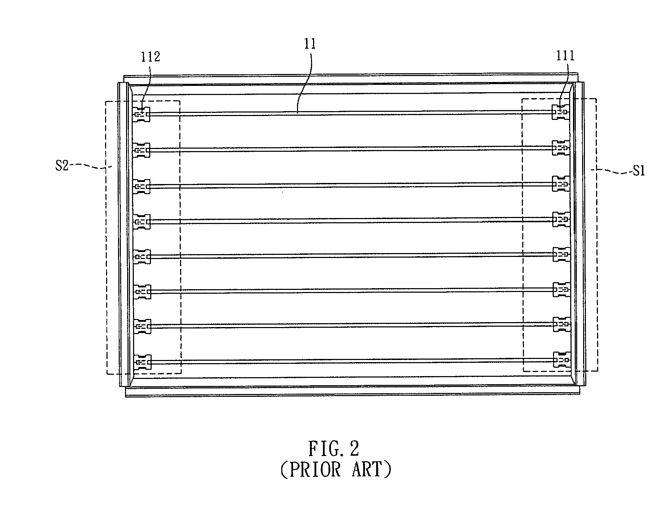

As for the above-mentioned backlight module, when the light-emitting unit 11 is the cold cathode fluorescent lamp, the brightness at the first end of the lamp for receiving the high-voltage driving signal is higher than the brightness at the second end of the lamp due to the properties of cold cathode fluorescent lamps. In other words, as shown in FIG. 2, when a greater number of cold cathode fluorescent lamps are utilized in a backlight module 2 of a large-scale LCD device, the brightness at a first side S1 of the LCD device for receiving the high-voltage driving signal is noticeably higher than the brightness at a second side S2 of the LCD device. Thus, the LCD device has non-uniform brightness, thereby influencing the display quality.

As mentioned hereinabove, it is an important subject of the invention to provide a backlight module possessing reduced cost and better lighting uniformity, and a driving circuit module of the backlight module.

### SUMMARY OF THE INVENTION

In view of the foregoing, the invention is to provide a backlight module possessing reduced cost and better lighting uniformity, and a driving circuit module thereof.

To achieve the above, the invention discloses a backlight module, which includes a first driving circuit board, a second driving circuit board, a first light-emitting unit, and a second light-emitting unit. The first driving circuit board has a first power supply circuit and a first current return circuit. The second driving circuit board has a second power supply circuit and a second current return circuit. The first light-emitting unit has a first end, which is directly electrically connected to the first power supply circuit of the first driving circuit board, and a second end, which is directly electrically connected to the second current return circuit of the second driving circuit board. The second light-emitting unit has a first end, which is directly electrically connected to the second power supply circuit of the second driving circuit board, and a second end, which is directly electrically connected to the first current return circuit of the first driving circuit board.

As mentioned above, the backlight module according to the invention utilizes the first driving circuit board and the second driving circuit board to provide the power signals for the light-emitting units with to the interlaced power supply circuits. Thus, the light source generated by the backlight module has uniform brightness.

To achieve the above, the invention also discloses a driving circuit module used in conjunction with a first light-emitting unit and a second light-emitting unit. The driving circuit module includes a first driving circuit board and a second driving circuit board. The first driving circuit board has a first power supply circuit and a first current return circuit. The first power supply circuit is electrically connected to a first end of the first light-emitting unit. The first current return circuit is electrically connected to a second end of the second light-emitting unit. The second driving circuit board has a second power supply circuit and a second current return circuit. The second power supply circuit is electrically connected to a first end of the second light-emitting unit, and the second current return circuit electrically connected to a second end of the first light-emitting unit.

As mentioned above, the driving circuit module according to the invention utilizes the first driving circuit board and the second driving circuit board to provide the power signals for the light-emitting units according to the interlaced power supply circuits. Thus, the light source generated by the light-emitting units, which is driven by the driving circuit module, has uniform brightness.

### BRIEF DESCRIPTION OF THE DRAWINGS

The invention will become more fully understood from the detailed description given herein below illustration only, and thus is not limitative of the present invention, and wherein:

FIG. 1 is a schematic illustration showing main composition of a conventional backlight module;

FIG. 2 is a schematic illustration showing the brightness distribution of a plurality of light-emitting units of the conventional backlight module;

FIG. 3 is a schematic illustration showing the main composition of a backlight module according to a preferred embodiment of the invention;

FIGS. 4A and 4B are schematic illustrations showing the main element composition of a driving circuit board in the backlight module according to the preferred embodiment of the invention, wherein FIG. 4A shows the main elements of the first driving circuit board, and FIG. 4B shows the main elements of the second driving circuit board;

FIGS. 5A and 5B are schematic illustrations showing the main composition of the backlight module for driving four light-emitting units according to an example of the preferred embodiment of the invention;

FIG. 6 is a schematic illustration showing the main composition of the backlight module for driving four light-emitting units according to another example of the preferred embodiment of the invention;

FIGS. 7A and 7B are schematic illustrations showing the main composition of the backlight module for driving four light-emitting units according to still another example of the preferred embodiment of the invention; and

FIG. 8 is a schematic illustration showing the main composition of the backlight module for driving eight light-emitting units according to an example of the preferred embodiment of the invention.

### DETAILED DESCRIPTION OF THE INVENTION

The present invention will be apparent from the following detailed description, which proceeds with reference to the accompanying drawings, wherein the same references relate to the same elements.

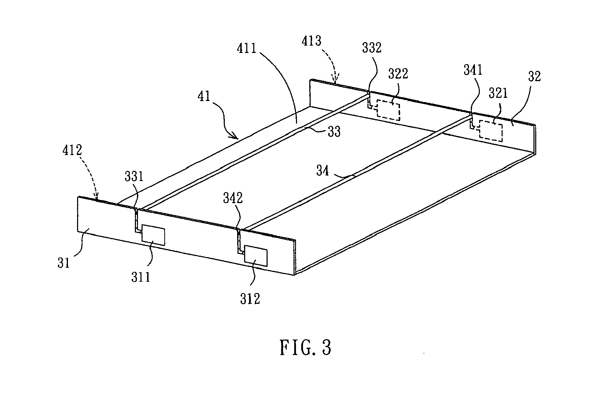

Referring to FIG. 3, a backlight module 3 according to a preferred embodiment of the invention is used in conjunction with a housing 41 and includes a first driving circuit board 31, a second driving circuit board 32, a first light-emitting unit 33 and a second light-emitting unit 34. The housing 41 has a reflective surface 411 and a first side surface 412 and a second side surface 413, both of which are substantially perpendicular to the reflective surface 411. The first side surface 412 and the second side surface 413 are disposed opposite to each other. In this embodiment, the first driving circuit board 31 is disposed on the first side surface 412 of the housing 41 and the second driving circuit board 32 is disposed on the second side surface 413 of the housing 41.

As shown in FIG. 3, the first driving circuit board 31 has a first power supply circuit 311 and a current return circuit 312, and the second driving circuit board 32 has a second power supply circuit 321 and a second current return circuit 322. The first power supply circuit 311 generates a first power signal, and the second power supply circuit generates a second power signal.

The first light-emitting unit 33 has a first end 331 directly electrically connected to the first power supply circuit 311 of the first driving circuit board 31, and a second end 332 directly electrically connected to the second current return circuit 322 of the second driving circuit board 32. In addition, the second light-emitting unit 34 has a first end 341 directly electrically connected to the second power supply circuit 321 of the second driving circuit board 32, and a second end 342 directly electrically connected to the first current return circuit 312 of the first driving circuit board 31. In this embodiment, the first power signal generated by the first power supply circuit 311 drives the first light-emitting unit 33, while the second power signal generated by the second power supply circuit 321 drives the second light-emitting unit 34.

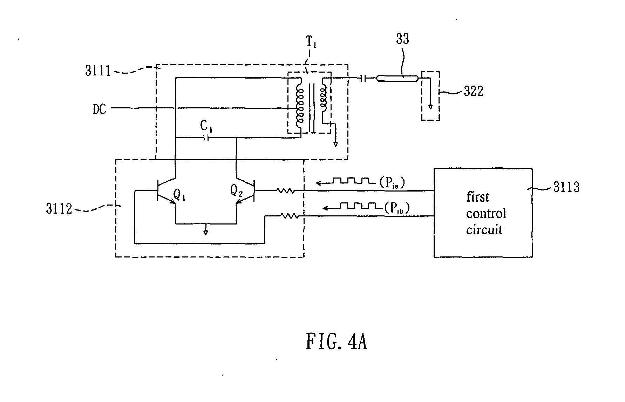

Referring to FIG. 4A, the first power supply circuit 311 of this embodiment includes a first step-up circuit 3111, a first switching circuit 3112 and a first control circuit 3113. The second current return circuit 322 is electrically connected to a grounding circuit or a signal feedback circuit through at least one metal wire. As shown in FIG. 4A, the first control circuit 3113 generates at least one set of switching signals Pᵢₐ and P_{ib}, and the first switching circuit 3112 turns on/off according to the set of switching signals Pᵢₐ and P_{ib}. The first step-up circuit 3111 generates the first power signal to drive the first light-emitting unit 33 according to the turn-on/off operation of the first switching circuit 3112. In this embodiment, the first step-up circuit 3111 includes a transformer T₁ and a capacitor C₁, and the first switching circuit 3112 includes two bipolar transistors Q₁ and Q₂, which are electrically connected to a first end of the capacitor C₁, and turn on/off according to the switching signals Pᵢₐ and P_{ib} generated by the first control circuit 3113. In addition, the first control circuit 3113 may be an analog switching signal generating circuit, a single chip or a digital processor.

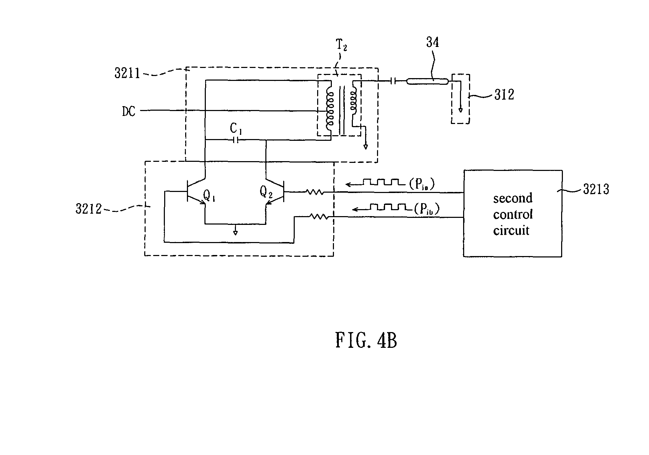

Referring to FIG. 4B, the second power supply circuit 321 includes a second step-up circuit 3211, a second switching circuit 3212 and a second control circuit 3213. The second step-up circuit 3211 and the first step-up circuit 3111 have the same components, the second switching circuit 3212 and the first switching circuit 3112 have the same components, and the second control circuit 3213 and the first control circuit 3113 also have the same components. The operation principles thereof are the same as those mentioned hereinabove, so detailed descriptions thereof will be omitted. It is to be specified that the second switching circuit 3212 of the second power supply circuit 321 may also turn on/off according to the set of switching signals Pᵢₐ and P_{ib} generated by the first control circuit 3113 of the first power supply circuit 311. In other words, the backlight module only needs one control circuit. In addition, the first current return circuit 312, which is also the same as the second current return circuit 322, is electrically connected to the grounding circuit or the signal feedback circuit through the at least one metal wire. The operation principles of the first current return circuit 312 and the second current return circuit 322 are the same, and detailed descriptions thereof will be omitted. In addition, it is appreciated that a voltage at the second end 332 of the first light-emitting unit 33, which is electrically connected to the second current return circuit 322, is lower than 200 volts, and the voltage at the second end 342 of the second light-emitting unit 34, which is electrically connected to the first current return circuit 312, is lower than 200 volts.

Furthermore, when the driving circuit module according to the preferred embodiment of the invention is applied to the large-scale LCD device, more light-emitting units have to be driven simultaneously. In the following, the driving circuit module according to the preferred embodiment of the invention will be further described by taking the driving circuit module for driving four light-emitting units as an example.

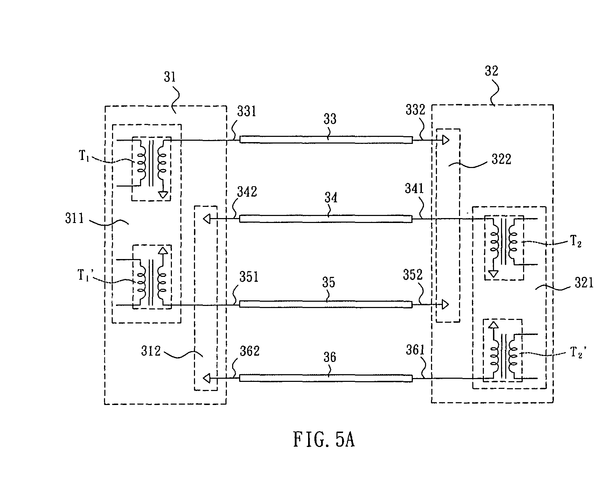

Referring to FIG. 5A, in addition to the above-mentioned architecture, the driving circuit module further includes a third light-emitting unit 35 and a fourth light-emitting unit 36. The third light-emitting unit 35 has a first end 351 electrically connected to the first power supply circuit 311 of the first driving circuit board 31, and a second end 352 electrically connected to the second current return circuit 322 of the second driving circuit board 32. The fourth light-emitting unit 36 has a first end 361 electrically connected to the second power supply circuit 321 of the second driving circuit board 32, and a second end 362 electrically connected to the first current return circuit 312 of the first driving circuit board 31.

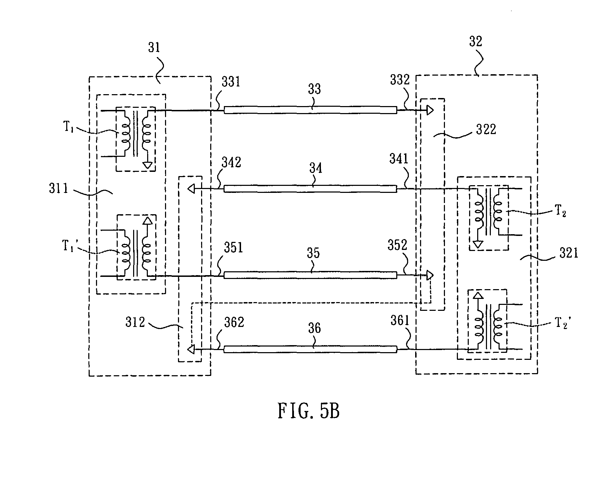

Referring to FIG. 5A, the first power supply circuit 311 has two first transformers T₁ and T₁', wherein the first power signal generated by the first transformer T₁ drives the first light-emitting unit 33, and the first power signal generated by the first transformer T₁' drives the third light-emitting unit 35. The second power supply circuit 321 has two second transformers T₂ and T₂', wherein the second power signal generated by the second transformer T₂ drives the second light-emitting unit 34, and the second power signal generated by the second transformer T₂' drives the fourth light-emitting unit 36. In this embodiment, as shown in FIG. 5B, the first current return circuit 312 of the first driving circuit board 31 may be electrically connected to the second current return circuit 322 of the second driving circuit board 32 according to the requirement on the actual design, so that an independent current return circuit may be formed.

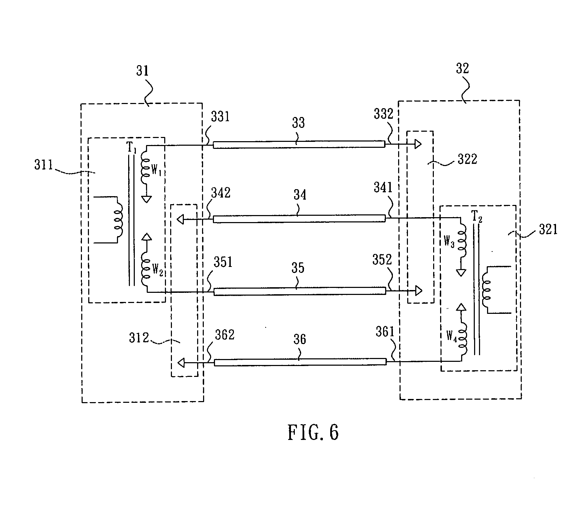

Each of the first power supply circuit 311 and the second power supply circuit 321 utilizes one transformer to drive one light-emitting unit. In addition, one transformer may be utilized to drive two light-emitting units, as shown in FIG. 6. The secondary side of the first transformer T₁ of the first power supply circuit 311 has two sets of coils W₁ and W₂, which are electrically connected to the first end 331 of the first light-emitting unit 33 and the first end 351 of the third light-emitting unit 35, respectively, in order to drive the first light-emitting unit 33 and the third light-emitting unit 35. The second end 332 of the first light-emitting unit 33 and the second end 352 of the third light-emitting unit 35 are electrically connected to the second current return circuit 322 of the second driving circuit board 32. The secondary side of the second transformer T₂ of the second power supply circuit 321 also has two sets of coils W₃ and W₄, which are electrically connected to the first end 341 of the second light-emitting unit 34 and the first end 361 of the fourth light-emitting unit 36, respectively, in order to drive the second light-emitting unit 34 and the fourth light-emitting unit 36. The second end 342 of the second light-emitting unit 34 and the second end 362 of the fourth light-emitting unit 36 are electrically connected to the first current return circuit 312 of the first driving circuit board 31.

Herein, it is appreciated that a phase difference between phases of the first power signals for driving the first light-emitting unit 33 and the third light-emitting unit 35 may be equal to 0 or 180 degrees according to the requirement on the actual design; and a phase difference between phases of the second power signals for driving the second light-emitting unit 34 and the fourth light-emitting unit 36 may also be equal to 0 or 180 degrees.

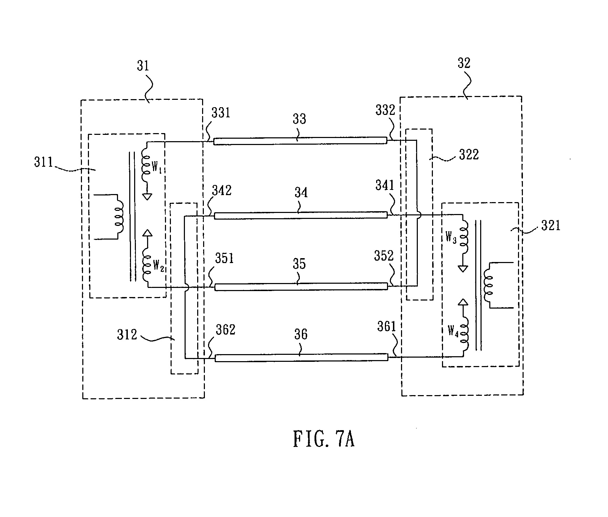

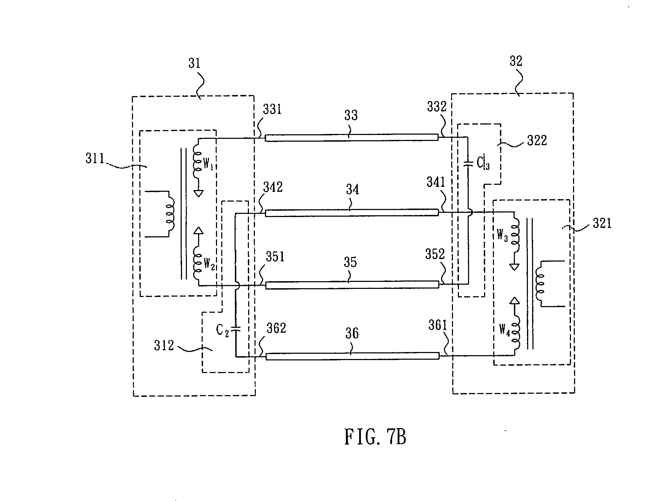

Also, as shown in FIG. 7A, the second current return circuit 322 may be formed by directly electrically connecting the second end 332 of the first light-emitting unit 33 to the second end 352 of the third light-emitting unit 35; and the first current return circuit 312 may be formed by directly electrically connecting the second end 342 of the second light-emitting unit 34 to the second end 362 of the fourth light-emitting unit 36. In addition, as shown in FIG. 7B, the second current return circuit 322 may be formed by electrically connecting the second end 342 of the second light-emitting unit 34 to the second end 362 of the fourth light-emitting unit 36 through a first capacitor C₂; and the first current return circuit 312 may be formed by electrically connecting the second end 332 of the first light-emitting unit 33 to the second end 352 of the third light-emitting unit 35 through a second capacitor C₃.

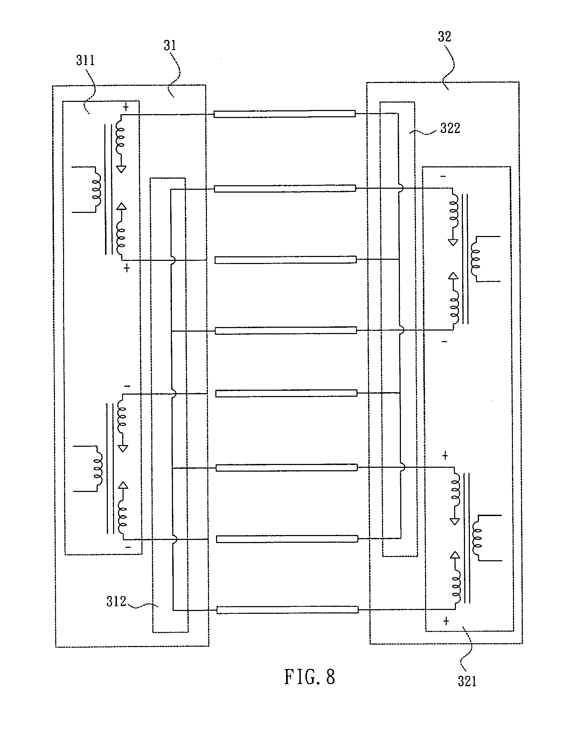

When the required number of the light-emitting units is larger, such as eight, different modifications may be implemented according to the requirement on actual design, as shown in FIG. 8.

As mentioned hereinabove, the backlight module according to the invention utilizes the first driving circuit board and the second driving circuit board to provide the power signals for the light-emitting units according to the interlaced power supply circuits. When the backlight module is applied to a larger scale LCD device and thus needs to use more light-emitting units, the power signals are provided to the light-emitting units alternately such that the light source generated by the light-emitting units, which is driven by the driving circuit module, has uniform brightness. In addition, disposing the driving circuit board on the side surface of the housing of the backlight module enables the light-emitting units to be directly electrically connected to the driving circuit board without any high voltage connection assembly for connecting the light-emitting unit to the driving circuit board. In other words, the power signals generated by the driving circuit board are directly inputted to the light-emitting units so that the cost of the high-voltage connection assembly can be reduced.

The backlight module according to the preferred embodiment of the invention has been described hereinabove.

The driving circuit module of the invention will be described in the following.

The features of the driving circuit module according to the preferred embodiment of the invention are the same as those stated hereinabove. So, detailed descriptions thereof will be omitted for the sake of simplicity.

That is, the driving circuit module according to the preferred embodiment of the invention includes a first driving circuit board 31 and a second driving circuit board 32, and is used in conjunction with a first light-emitting unit 33, a second light-emitting unit 34 and a housing 41, as shown in FIG. 3.

The housing 41 has a reflective surface 411 and a first side surface 412 and a second side surface 413, both of which are substantially perpendicular to the reflective surface 411. The first side surface 412 and the second side surface 413 are disposed opposite to each other. In this embodiment, the first driving circuit board 31 is disposed on the first side surface 412 of the housing 41, and the second driving circuit board 32 is disposed on the second side surface 413 of the housing 41.

The first driving circuit board 31 has a first power supply circuit 311 and a first current return circuit 312. The first power supply circuit 311 is electrically connected to the first end 331 of the first light-emitting unit 33, and the first current return circuit 312 is electrically connected to the second end 342 of the second light-emitting unit 34. The second driving circuit board 32 has a second power supply circuit 321 and a second current return circuit 322. The second power supply circuit 321 is electrically connected to the first end 341 of the second light-emitting unit 34, and the second current return circuit 322 is electrically connected to the second end 332 of the first light-emitting unit 33.

In summary, the driving circuit module according to the invention utilizes the first driving circuit board and the second driving circuit board to provide the power signals for the light-emitting units according to the interlaced power supply circuits. When the driving circuit module is applied to the larger scale LCD device and thus needs more light-emitting units, the power signals are provided to the light-emitting units alternately, such that the light source generated by the light-emitting units, which is driven by the driving circuit module, has uniform brightness.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A backlight module, comprising:
a first driving circuit board having a first power supply circuit and a first current return circuit;
a second driving circuit board having a second power supply circuit and a second current return circuit;
a first light-emitting unit having a first end directly electrically connected to the first power supply circuit of the first driving circuit board, and a second end directly electrically connected to the second current return circuit of the second driving circuit board; and
a second light-emitting unit having a first end directly electrically connected to the second power supply circuit of the second driving circuit board, and a second end directly electrically connected to the first current return circuit of the first driving circuit board.

2. The backlight module according to claim 1, further comprising:
a third light-emitting unit having a first end directly electrically connected to the first power supply circuit of the first driving circuit board, and a second end directly electrically connected to the second current return circuit of the second driving circuit board.

3. The backlight module according to claim 2, wherein the second end of the third light-emitting unit is electrically connected to the second end of the first light-emitting unit through the second current return circuit of the second driving circuit board.

4. The backlight module according to claim 2, wherein the first power supply circuit comprises a first step-up circuit for generating first power signals to drive the first light-emitting unit and the third light-emitting unit, respectively.

5. The backlight module according to claim 4, wherein a phase difference between phases of the first power signals for driving the first light-emitting unit and the third light-emitting unit is equal to 0 degree or 180 degrees.

6. The backlight module according to claim 1, further comprising:
a third light-emitting unit having a first end electrically connected to the second power supply circuit of the second driving circuit board, and a second end electrically connected to the first current return circuit of the first driving circuit board.

7. The backlight module according to claim 6, wherein the second end of the third light-emitting unit is directly electrically connected to the second end of the second light-emitting unit through the first current return circuit of the first driving circuit board.

8. The backlight module according to claim 6, wherein the second power supply circuit comprises a second step-up circuit for generating second power signals to drive the second light-emitting unit and the third light-emitting unit, respectively.

9. The backlight module according to claim 8, wherein a phase difference between phases of the second power signals for driving the second light-emitting unit and the third light-emitting unit is equal to 0 degree or 180 degrees.

10. The backlight module according to claim 1, further comprising a housing having a reflective surface, a first side surface and a second side surface, wherein the first side surface and the second side surface are substantially perpendicular to the reflective surface, the first side surface is disposed opposite to the second side surface, the first driving circuit board is disposed on the first side surface, and the second driving circuit board is disposed on the second side surface.

11. The backlight module according to claim 1, wherein the first power supply circuit comprises at least a first step-up circuit for generating a first power signal to drive the first light-emitting unit, and the second power supply circuit comprises at least a second step-up circuit for generating a second power signal to drive the second light-emitting unit.

12. The backlight module according to claim 1, wherein a voltage at the second end of the first light-emitting unit electrically connected to the second current return circuit is smaller than 200 volts.

13. The backlight module according to claim 1, wherein a voltage at the second end of the second light-emitting unit electrically connected to the first current return circuit is smaller than 200 volts.

14. A driving circuit module used in conjunction with a first light-emitting unit and a second light-emitting unit, the driving circuit module comprising:
a first driving circuit board having a first power supply circuit electrically connected to a first end of the first light-emitting unit, and a first current return circuit electrically connected to a second end of the second light-emitting unit; and
a second driving circuit board having a second power supply circuit electrically connected to a first end of the second light-emitting unit, and a second current return circuit electrically connected to a second end of the first light-emitting unit.

15. The driving circuit module according to claim 14, wherein the first power supply circuit of the first driving circuit board is further electrically connected to a first end of a third light-emitting unit, and the second current return circuit of the second driving circuit board is further electrically connected to a second end of the third light-emitting unit.

16. The driving circuit module according to claim 15, wherein the second end of the third light-emitting unit is directly electrically connected to the second end of the first light-emitting unit through the second current return circuit of the second driving circuit board.

17. The driving circuit module according to claim 15, wherein the first power supply circuit comprises a first step-up circuit for generating first power signals to drive the first light-emitting unit and the third light-emitting unit, respectively.

18. The driving circuit module according to claim 17, wherein a phase difference between phases of the first power signals for driving the first light-emitting unit and the third light-emitting unit is equal to 0 degree or 180 degrees.

19. The driving circuit module according to claim 14, wherein the second power supply circuit of the second driving circuit board is further electrically connected to a first end of a third light-emitting unit, and the first current return circuit of the first driving circuit board is further electrically connected to a second end of the third light-emitting unit.

20. The driving circuit module according to claim 19, wherein the second end of the third light-emitting unit is electrically connected to the second end of the second light-emitting unit through the first current return circuit of the first driving circuit board.

21. The driving circuit module according to claim 19, wherein the second power supply circuit comprises a second step-up circuit for generating second power signals to drive the second light-emitting unit and the third light-emitting unit, respectively.

22. The driving circuit module according to claim 21, wherein a phase difference between phases of the second power signals for driving the second light-emitting unit and the third light-emitting unit is equal to 0 degree or 180 degrees.

23. The driving circuit module according to claim 14, wherein the first power supply circuit comprises at least a first step-up circuit for generating a first power signal to drive the first light-emitting unit, and the second power supply circuit comprises at least a second step-up circuit for generating a second power signal to drive the second light-emitting unit.

24. The driving circuit module according to claim 14, wherein a voltage at the second end of the first light-emitting unit electrically connected to the second current return circuit is smaller than 200 volts.

25. The driving circuit module according to claim 14, wherein a voltage at the second end of the second light-emitting unit electrically connected to the first current return circuit is smaller than 200 volts.
